(19) Europäisches Patentamt / European Patent Office / Office européen des brevets

(11) **EP 3 648 354 B1**

(12) **EUROPEAN PATENT SPECIFICATION**

(45) Date of publication and mention
of the grant of the patent:
**06.12.2023 Bulletin 2023/49**

(21) Application number: **18203422.3**

(22) Date of filing: **30.10.2018**

(51) International Patent Classification (IPC):
*H03M 3/00* $^{(2006.01)}$   *H03H 7/01* $^{(2006.01)}$
*H03H 1/02* $^{(2006.01)}$

(52) Cooperative Patent Classification (CPC):
**H03M 3/458;** H03H 7/06

(54) **PASSIVE LOW-PASS FILTER SYSTEM FOR PULSE DENSITY DIGITAL-TO-ANALOG CONVERTERS**

PASSIVES TIEFPASSFILTERSYSTEM FÜR DIGITAL-ANALOG-IMPULSDICHTENWANDLER

SYSTÈME DE FILTRE PASSE-BAS PASSIF POUR CONVERTISSEURS NUMÉRIQUES-ANALOGIQUES À DENSITÉ D'IMPULSIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**06.05.2020 Bulletin 2020/19**

(73) Proprietor: **Integrated Device Technology, Inc. San Jose, CA 95138 (US)**

(72) Inventor: **SCHREIBER, Ronald**
**01705 Freital (DE)**

(74) Representative: **Lippert Stachow Patentanwälte Rechtsanwälte**
**Partnerschaft mbB**
**Krenkelstraße 3**
**01309 Dresden (DE)**

(56) References cited:
**US-A- 5 815 051      US-A1- 2012 007 215**
**US-A1- 2016 373 101**

• **KYOUNGSIK KANG ET AL: "Class-D Audio Amplifier Using 1-Bit Fourth-Order Delta-Sigma Modulation", IEEE TRANSACTIONS ON CIRCUITS AND SYSTEMS II: EXPRESS BRIEFS, IEEE, US, vol. 55, no. 8, 1 August 2008 (2008-08-01) , pages 728-732, XP011333956, ISSN: 1549-7747, DOI: 10.1109/TCSII.2008.922457**

EP 3 648 354 B1

## Description

The invention relates to a passive low filter system for pulse density digital-to-analog converters.

A pulse density digital-to-analog converter comprises a digital pulse density modulator, which converts a low-bandwidth high resolution signal into a high bandwidth low-resolution signal, a high bandwidth low-resolution digital-to-analog converter, and an analog reconstruction filter.

Pulse-density modulation (PDM) is a form of modulation used to represent an analog signal with a binary signal. In a PDM signal the relative density of the pulses corresponds to the analog signal amplitude. In a PDM bitstream a digital 1 corresponds to a pulse positive polarity and a digital 0 corresponds to a negative polarity. A run consisting of all digital 1s therefore correspond to the maximum (positive) amplitude value, a run consisting of all digital 0s correspond to the minimum (negative) value, and a run consisting of alternating 1a and 0s correspond to a zero-amplitude value.

A special form of pulse-density modulation (PDM) is pulse-width modulation (PWM). In a PWM signal the widths of the pulses correspond to specific analog values. The pulses of various lengths will be sent at regular intervals, which is the carrier frequency of the modulation.

Furthermore, an analog-to-digital converter can use a so-called delta-sigma ($\Delta\Sigma$), also called sigma-delta ($\Sigma\Delta$), modulation. The first step in a delta-sigma modulation is delta modulation, in which the change in the signal (its delta) is encoded, rather than the absolute value. The result is a stream of pulses, which represent a PDM signal.

Delta-sigma modulation uses oversampling and noise shaping to push the discretization noise of the low-resolution signal to higher frequencies. In one of the simplest implementations the error (difference) between the high-resolution input and the low-resolution output is accumulated. In the next sampling step this accumulated error is converted again to the low-resolution output. The closed loop operation of the delta-sigma modulator makes the mean of the low-resolution output signal equal to the high-resolution input signal. By averaging the low-resolution output signal the high-resolution input signal can be reconstructed.

An Advantage of PDM, PWM and delta-sigma modulation is that a high bandwidth low-resolution digital-to-analog converter is easier to implement than a low-bandwidth high resolution digital-to-analog converter. The simplest form of a high bandwidth low-resolution digital-to-analog converter is a 1-bit converter.

A reconstruction filter is used to recover the low-bandwidth high resolution analog signal from the high bandwidth low-resolution analog signal of the digital-to-analog converter. This is done by low-pass filtering (averaging) the output signal of high bandwidth low-resolution digital-to-analog converter. The reconstruction filter can be generally implemented with various filter orders and as an active or passive filter. A higher filter order allows a better suppression of high frequency content. Passive filters have lower costs in terms of component count, current consumption and chip size than active filters and do not add offset errors and non-linearities. However, high order passive filters have the disadvantage of high output impedance. Since the output impedance of the reconstruction filter causes an additional error, a low output impedance is desired in the signal band to minimize the additional error.

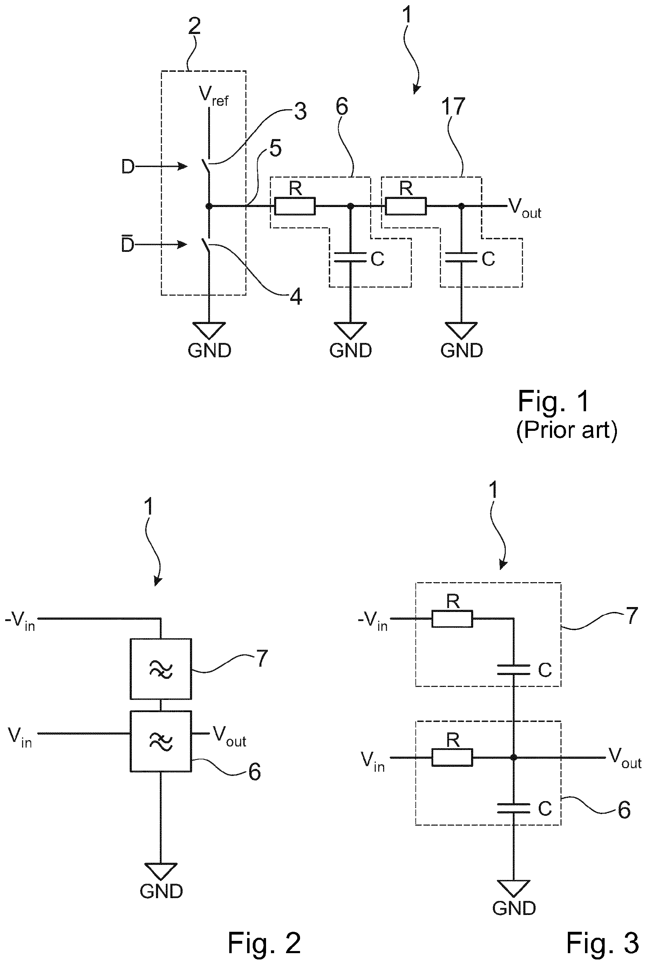

An example of a known passive second order reconstruction filter known from the prior art is a series connection of two resistor-capacitor (RC) low-pass filters (as shown in Fig. 1). The transfer function of such a reconstruction filter is defined by:

$$H(p) = \frac{1}{R^2 C^2 p^2 + 3RC\,p + 1}$$

The corner frequency of such a reconstruction filter is defined by:

$$f_c = \frac{\sqrt{13} - 3}{4\pi\,R\,C}$$

And the output impedance of the reconstruction filter is defined by:

$$Z_o(p) = R\,\frac{RC\,p + 2}{R^2 C^2 p^2 + 3RC\,p + 1}$$

US 5,815,051 discloses differential filters for removing both normal-mode and common-mode noises. A first-order differential low pass filter is composed of a first resistor connected between a first input terminal and a first output terminal, a second resistor having the same resistance value as the first resistor and connected between a second input terminal and a second output terminal, a first capacitor connected between the first output terminal and a reference potential, a second capacitor having the same capacitance value as the first capacitor and connected between the second output terminal and the reference potential, and a third capacitor connected between the first output terminal and the second output terminal.

US 2016/0373101 A1 disclosed an integrated constant time delay circuit utilized in continuous-time (CT) analog-to-digital converters (ADCs) that can be implemented with an RC lattice structure to provide, e.g., a passive all-pass lattice filter. Additional poles created by decoupling capacitors can be used to provide a low-pass filtering effect in some embodiments. A Resistor-Capacitor "RC" lattice structure can be an alternative to a constant-resistance Inductor-Capacitor "LC" lattice implementation. ADC architectures benefit from the RC implementation.

US 2012/0007215 A1 discloses that at least a first capacitor is formed on a substrate and connected to a first differential node of a differential circuit, and the first capacitor may be variable in capacitance. A second capacitor is formed on the substrate and connected to a second differential node of the differential circuit, and the second capacitor also may be variable. A third capacitor is connected between the first differential node and the second differential node, and is formed at least partially above the first capacitor. In this way, a size of the first capacitor and/or the second capacitor may be reduced on the substrate and capacitances of the first and/or second capacitor(s) may be adjusted in response to a variable characteristic of one or more circuit components of the differential circuit.

Thus, it is an object of the present invention to provide a low-pass filter system for pulse density digital-to-analog converters that is performing at least second order filtering, is cost efficient, pure passive and has a lower output impedance than the known passive low-pass filter system for pulse density digital-to-analog converters.

This object is solved by a passive low-pass filter system for pulse density digital-to-analog converters according to claim 1.

The passive low-pass filter system comprises a positive voltage input, a negative voltage input, a voltage output, a low-pass filter and a high-pass filter, wherein the positive voltage input is connected to the low-pass filter, the voltage output corresponds to the output of the low-pass filter, the negative voltage input is connected to the high-pass filter and the output of the high-pass filter is connected to the voltage output.

The output impedance of such a passive low-pass filter system at direct current (DC) and low-frequency is half of the output impedance of the passive low-pass filter system of the prior art comprising a positive voltage input, two low-pass filters connected in series and a voltage output at the second low-pass filter. At the same time the transfer function H(p) of the low-pass filter system is still the same as for the low-pass filter system of the prior art.

According to the invention the low-pass filter and the high-pass filter is a resistor-capacitor circuit. In this variant the costs, especially with respect to component costs and/or chip size, is identical respectively very similar to the low-pass filter system of the prior art because in both cases each filter consists of a resistor and a capacitor.

The positive voltage input is connected to the resistor of the first resistor-capacitor circuit, the capacitor of the first resistor-capacitor circuit is connected to ground and the voltage output is located between the resistor and the capacitor of the first resistor-capacitor circuit and/or the negative voltage input is for example connected to the resistor of the second resistor-capacitor circuit and the capacitor of the second resistor-capacitor circuit is connected to the voltage output or the negative voltage input is for example connected to the capacitor of the second resistor-capacitor circuit and the resistor of the second resistor-capacitor circuit is connected to the voltage output.

The transfer function of such a low-pass filter system according to the invention is defined by:

$$H(p) = \frac{1}{R^2 C^2 p^2 + 3RC\,p + 1}$$

The corner frequency of low-pass filter system according to the invention is defined by:

$$f_c = \frac{\sqrt{13} - 3}{4\pi\,RC}$$

And the output impedance of the low-pass filter system according to the invention is defined by:

$$Z_o(p) = R\,\frac{RC\,p + 1}{R^2 C^2 p^2 + 3RC\,p + 1}$$

Thus, the output impedance of such a passive low-pass filter system at direct current (DC) and low-frequency is half of the out impedance of the passive low-pass filter system according to the prior art.

According to a particularly preferred variant of the invention a first digital-to-analog converter is connected to the positive voltage input and a second digital-to-analog converter is connected to the negative voltage input. By using two digital-to-analog converters it is very easy to generate the negative voltage input and at the same time the additional costs for a second digital-to-analog converter are very small.

In this variant the first digital-to-analog converter provides for example a reference voltage to the positive voltage input in case of a digital one signal and connects the positive voltage input to ground in case of a digital zero signal and/or the second digital-to-analog converter provides for example a reference voltage to the negative voltage input in case of a digital zero signal and connects the negative voltage input to ground in case of a digital one signal.

According to a preferred variant of the invention the first digital-to-analog converter and/or the second digital-to-analog converter comprise mechanical or electronic switches, preferably MOS-transistor switches.

In an advantageous variant a D-type flip-flop is located at the input of the digital signal input, wherein the D-type flip-flop has an output and an inverted output. The D-type flip-flop delays the signal at the data input until an edge of the signal at the clock input is detected. The D-type flip-flop is used to synchronize the high bandwidth low-resolution signal at the data input of the digital-to-analog converter.

Advantageously a decoupling circuit is connected to the D-type flip-flop to decouple the output of the D-type flip-flop from the inverted output of the D-type flip-flop. In this way a non-overlapping control of the digital-to-analog switches is provided, by which cross-currents from the reference voltage to ground can be avoided.

In an advantageous variant the decoupling circuit comprises two NOR-gates, each NOR-gate having a first input, a second input and an output, wherein the first input of the first NOR-gate is connected to the output of the D-type flip-flop and the second input of the first NOR-gate is connected to the output of the second NOR-gate, and wherein the first input of the second NOR-gate is connected to the inverted output of the D-type flip-flop and the second input of the second NOR-gate is connected to the output of the first NOR-gate. Preferably the output of the first NOR-gate and/or the output of the second NOR-gate comprises a delay member, preferably arranged before the feedback of the output signal to the second input of the other NOR-gate. The delay members are preferably used because of the feedback of the output of the first/second NOR-gate to the second/first NOR-gate.

In a preferred variant the output of the D-type flip-flop is connected to the switch between the reference voltage and the low-pass filter and to the switch between ground and the high-pass filter and the inverted output of the D-type flip-flop is connected to the switch between ground and the low-pass filter and to the switch between the reference voltage and the high-pass filter.

In the following the invention will be further explained with respect to the embodiments shown in the figures. It shows:

Fig. 1 a circuit diagram of a passive low-pass filter system for pulse density digital-to-analog converters according to the prior art,

Fig. 2 a simplified circuit diagram of a passive low-pass filter system for pulse density digital-to-analog converters not forming part of the claimed invention but useful for understanding the claimed invention.

Fig. 3 a detailed circuit diagram of a passive low-pass filter system for pulse density digital-to-analog converters according to a first embodiment of the invention,

Fig. 4a a transfer function diagram of passive low-pass filter systems according to the prior art and according to the invention,

Fig. 4b an output impedance diagram of passive low-pass filter systems according to the prior art and according to the invention,

Fig. 5 a circuit diagram of a passive low-pass filter system for pulse density digital-to-analog converters according to a second embodiment of the invention, and

Fig. 6 a circuit diagram of a passive low-pass filter system for pulse density digital-to-analog converters according to a third embodiment of the invention.

Fig. 1 shows a circuit diagram of a passive low-pass filter system 1 for a pulse density digital-to-analog converter according to the prior art. The digital-to-analog converter 2 comprises a first switch 3, and second switch 4 and an output 5. The first switch 3 is connected to a digital data input D, the second switch 4 is connected to an inverted data input $\overline{D}$ and in case of a digital one signal a reference voltage $V_{ref}$ is provided to the output 5 of the digital-to-analog converter 2 by closing the first switch 3 and in case of a digital zero signal the output 5 of the digital-to-analog converter 2 is connected to ground by the second switch 4.

The output 5 of the digital-to-analog converter 2 is connected to a series connection of a first low-pass filter 6 and a second low-pass filter 17, wherein the second low-pass filter 17 provides the output $V_{out}$ of the passive low-pass filter system 1.

According to Fig. 1 the first low-pass filter 6 and the second low-pass filter 17 each consist of a resistor R and a capacitor C, wherein the resistor R of the first low-pass filter 6 is connected on the one side to the output 5 of the digital-to-analog converter 2 and on the other side to the capacitor C of the first low-pass filter 6 and the capacitor of the first low-pass filter 6 is connected on the one side to the resistor R of the first low-pass filter 6 and on the other side to ground. The resistor R of the second low-pass filter 17 is connected on the one side to the resistor R and capacitor C of the first low-pass filter 6 and on the other side to the capacitor C of the second low-pass filter 17 and the capacitor C of the second low-pass filter 17 is connected on the one side to the resistor R of the second low-pass filter 17 and on the other side to ground. The output $V_{out}$ of the passive low-pass filter system 1 is provided between the resistor R and capacitor C of the second low-pass filter 17.

The transfer function of such a passive low-pass filter system 1 according to the prior art is defined by:

$$H(p) = \frac{1}{R^2 C^2 p^2 + 3RC\,p + 1}$$

The corner frequency of such a passive low-pass filter system 1 according to the prior art is defined by:

$$f_c = \frac{\sqrt{13} - 3}{4\pi RC}$$

And the output impedance of such a passive low-pass filter system 1 according to the prior art is defined by:

$$Z_o(p) = R\,\frac{RCp + 2}{R^2C^2p^2 + 3RCp + 1}$$

Fig. 2 shows a simplified circuit diagram of a passive low-pass filter system 1 for pulse density digital-to-analog converters not forming part of the claimed invention but useful for understanding the claimed invention. The passive low-pass filter system 1 of Fig. 2 comprises a positive voltage input $V_{in}$, a negative voltage input $-V_{in}$, a voltage output $V_{out}$, a low-pass filter 6 and a high-pass filter 7.

The positive voltage input $V_{in}$ is connected to the low-pass filter 6 and the voltage output $V_{out}$ of the passive low-pass filter system 1 corresponds to the output of the low-pass filter 6. The negative voltage input $-V_{in}$ is connected to the high-pass filter 7 and the output of the high-pass filter 7 is connected to the voltage output $V_{out}$ at the low-pass filter 6.

Fig. 3 shows a circuit diagram of a passive low-pass filter system 1 for pulse density digital-to-analog converters according to a first embodiment of the invention. In the invention the low-pass filter 6 and the high-pass filter 7 each consist of a resistor R and a capacitor C, so that the low-pass filter 6 and the high-pass filter 7 are resistor-capacitor (RC) circuits.

In the invention the resistor R of the low-pass filter 6 is connected on the one side to the positive voltage input $V_{in}$ and on the other side to the capacitor C of the low-pass filter 6 and the capacitor C of the low-pass filter 6 is connected on the one side to the resistor R of the low-pass filter 6 and on the other side to ground. The output of the low-pass filter 6, that corresponds to the output $V_{out}$ of the passive low-pass filter system 1, is located between the resistor R and capacitor C of the low-pass filter 6.

The resistor R of the high-pass filter 7 is connected on the one side to the negative voltage input $-V_{in}$ and on the other side to the capacitor C of the high-pass filter 7 and the capacitor C of the high-pass filter 7 is connected on the one side to the resistor R of the high-pass filter 7 and on the other side other side to the resistor R and capacitor C of the low-pass filter 6 and thus to the output $V_{out}$ of the passive low-pass filter system 1.

In other words, the positive voltage input $V_{in}$ is connected to the resistor R of the resistor-capacitor circuit of the low-pass filter 6, the capacitor C of the resistor-capacitor circuit of the low-pass filter 6 is connected to ground and the voltage output $V_{out}$ is located between the resistor R and the capacitor C of the resistor-capacitor circuit of the low-pass filter 6 and the negative voltage input $-V_{in}$ is connected to the resistor R of the resistor-capacitor circuit of the high-pass filter 7 and the capacitor C of the resistor-capacitor of the high-pass filter 7 circuit is connected to the voltage output $V_{out}$. Since the resistor-capacitor circuit of the high-pass filter 7 is a series connection of the resistor R and the capacitor C the sequence of the resistor R and the capacitor C can be exchanged.

The transfer function of such a low-pass filter system 1 according to Fig. 3 is defined by:

$$H(p) = \frac{1}{R^2C^2p^2 + 3RCp + 1}$$

The corner frequency of such a low-pass filter system 1 according to Fig. 3 is defined by:

$$f_c = \frac{\sqrt{13} - 3}{4\pi RC}$$

And the output impedance of such a low-pass filter system 1 according to Fig. 3 is defined by:

$$Z_o(p) = R\,\frac{RCp + 1}{R^2C^2p^2 + 3RCp + 1}$$

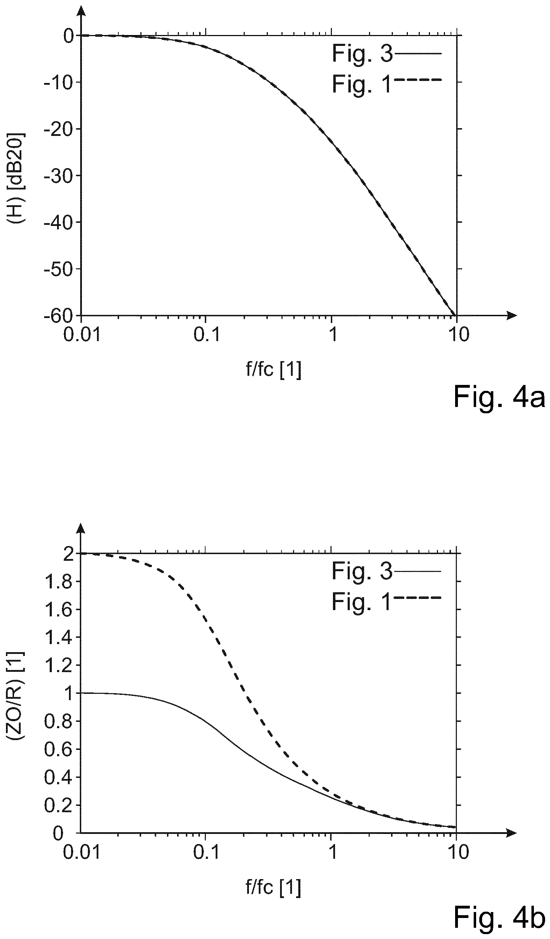

Fig. 4a shows a transfer function diagram of passive low-pass filter systems 1 according to the prior art as shown in Fig. 1 as a dashed line and according to the invention as shown in Fig. 3 as a solid line. The transfer function in Fig. 4a shows the output of the passive low-pass filter system 1 as a function of the frequency. Since the passive low-pass system 1 according to Fig. 1 and the passive low-pass system 1 according to Fig. 3 have the same transfer function H(p) the curves of both passive low-pass systems 1 are overlapping in Fig. 4a and thus only a solid line is visible.

Fig. 4b shows an output impedance diagram of passive low-pass filter systems 1 according to the prior art as shown in Fig. 1 as a dashed line and according to the invention as shown in Fig. 3 as a solid line. The output impedance is shown in Fig. 4b as a function of the frequency. As can be seen from Fig. 4b the output impedance of the passive low-pass filter system 1 according to Fig. 3 is half of the output impedance of the passive low-pass system 1 according to Fig. 1 for direct current and low frequencies.

At the same time the corner frequencies and the costs in terms of component count, current consumption and chip size for both passive low-pass systems 1 according to Figs. 1 and 3 are identical and/or highly similar.

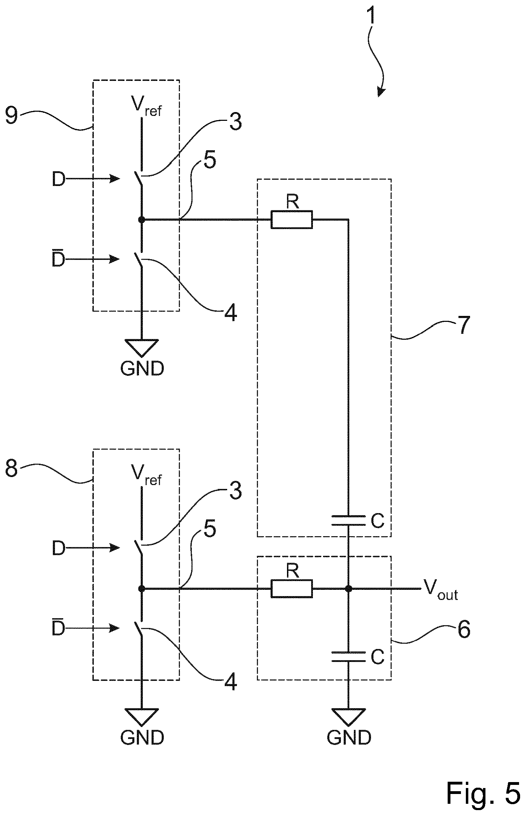

Fig. 5 shows a circuit diagram of a passive low-pass filter system 1 for pulse density digital-to-analog converters according to a second embodiment of the invention. The second embodiment of Fig. 5 bases on first embodiment shown in Fig. 3 and further comprises a first digital-to-analog converter 8 and a second digital-to-analog converter 9. The first digital-to-analog converter 8 is connected to the positive voltage input $V_{in}$ and the second digital-to-analog converter 9 is connected to the negative voltage input $-V_{in}$. The first digital-to-analog converter 8 and the second digital-to-analog converter 9 each comprise a first switch 3 and a second switch 4. The first digital-to-analog converter 8 provides a reference voltage $V_{ref}$ to the positive voltage input $V_{in}$ in case of a digital one signal at a data input D of the first digital-to-analog converter 8. This is achieved by the first switch 3 of the first digital-to-analog converter 8. In case of a digital one at the inverted data input D of the first digital-to-analog converter 8, which means that the digital data input D of the first digital-to-analog converter 8 is zero, the positive voltage input $V_{in}$ is connected to ground by the first digital-to-analog converter 8. This is achieved by the second switch 4 of the first digital-to-analog converter 8.

The second digital-to-analog converter 9 provides a reference voltage $V_{ref}$ to the negative voltage input $-V_{in}$ in case of a digital one at the inverted data input D of the second digital-to-analog converter 9, which means that the digital data input D of the second digital-to-analog converter 9 is zero. This is achieved by the first switch 3 of the second digital-to-analog converter 9. In case of a digital one at the data input D of the second digital-to-analog converter 9 the negative voltage input $-V_{in}$ is connected to ground by the second switch 4 of the second digital-to-analog converter 9.

The first and/or second switches 3, 4 of the first and/or second digital-to-analog converter 8, 9 can comprise mechanical or electronic switches, preferably MOS-transistor switches.

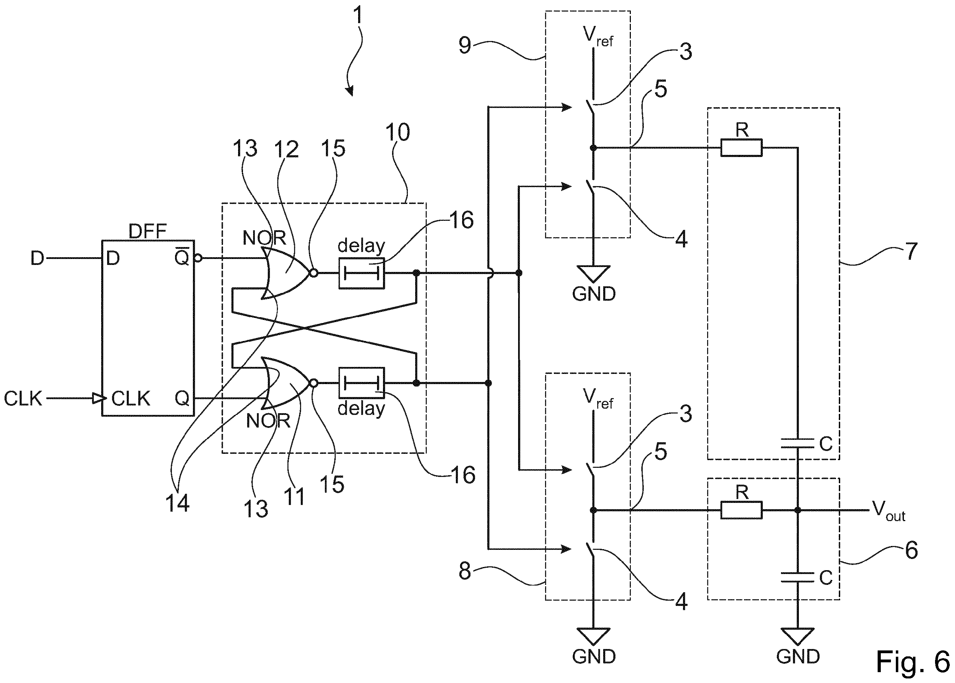

Fig. 6 shows a circuit diagram of a passive low-pass filter system 1 for pulse density digital-to-analog converters according to a third embodiment of the invention. The fourth embodiment of Fig. 6 bases on the second embodiment shown in Fig. 5 and further comprises a D-type flip-flop DFF at the digital signal input D and a decoupling circuit 10 between the D-type flip-flop DFF and the first and second digital-to-analog converters 8, 9.

The D-type flip-flop DFF has an output Q and an inverted output Q that correspond to the digital data input D and inverted digital data input D of the first and second digital-to-analog converters 8, 9 of Fig. 5. The D-type flip-flop further comprises a clock input CLK for a clock signal.

The decoupling circuit 10 is connected to the D-type flip-flop DFF to decouple the output Q of the D-type flip-flop DFF from the inverted output **Q** of the D-type flip-flop DFF.

The decoupling circuit 10 comprises a first NOR-gate 11 and a second NOR-gate 12, each NOR-gate 11, 12 having a first input 13, a second input 14 and an output 15. The first input 13 of the first NOR-gate 11 is connected to the output Q of the D-type flip-flop DFF and the second input 14 of the first NOR-gate 11 is connected to the output 15 of the second NOR-gate 12, and the first input 13 of the second NOR-gate 12 is connected to the inverted output **Q** of the D-type flip-flop DFF and the second input 14 of the second NOR-gate 12 is connected to the output 15 of the first NOR-gate 11.

The output 15 of the second NOR-gate 12 corresponds to the digital data input D of the passive low-pass filter system 1 of Fig. 5 and the output 15 of the first NOR-gate 11 corresponds to the inverted digital data input D of the passive low-pass filter system 1 of Fig. 5.

The output 15 of the first NOR-gate 11 and of the second NOR-gate 12 each comprises a delay member 16, arranged before the feedback of the output signal to the second input 14 of the other NOR-gate (12, 11).

The inverted output **Q** of the D-type flip-flop DFF is connected to the switch 3 of the first digital-to-analog converter 8 between the reference voltage $V_{ref}$ and the low-pass filter 6 and to the switch 4 of the second digital-to-analog converter 9 between ground and the high-pass filter 7 and the output Q of the D-type flip-flop DFF is connected to the switch 4 of the first digital-to-analog converter 8 between ground and the low-pass filter 6 and to the switch 4 of the second digital-to-analog converter 9 between the reference voltage $V_{ref}$ and the high-pass filter 7.

## List of references

1    passive low-pass system
2    digital-to-analog converter
3    first switch
4    second switch
5    output digital-to-analog converter
6    first low-pass filter
7    second high-pass filter
8    first digital-to-analog converter
9    second digital-to-analog converter
10   decoupling circuit
11   first NOR-gate
12   second NOR-gate
13   first input NOR-gate
14   second input NOR-gate
15   output NOR-gate
16   delay member
17   second low-pass filter
$V_{in}$    positive voltage input

-V$_{in}$   negative voltage input
V$_{out}$   voltage output
V$_{ref}$   reference voltage
D   digital data input
D   inverted digital data input
Q   output D-type flip-flop
$\bar{Q}$   inverted output D-type flip-flop
DFF   D-type flip-flop
CLK   input clock signal D-type flip-flop

**Claims**

1. Passive low-pass filter system (1) for pulse density digital-to-analog converters, comprising:

   a positive voltage input (V$_{in}$) and
   a negative voltage input (-Vin) forming together a differential input, a voltage output (V$_{out}$), a low-pass filter (6) and
   a high-pass filter (7), wherein
   the positive voltage input (V$_{in}$) is connected to the low-pass filter (6), the voltage output (V$_{out}$) corresponds to the output of the low-pass filter (6), the negative voltage input (-V$_{in}$) is connected to the high-pass filter (7) and the output of the high-pass filter (7) is connected to the voltage output (V$_{out}$),
   wherein the low-pass filter (6) and the high-pass filter (7) are each a resistor-capacitor circuit, each consisting of a resistor (R) with a corresponding resistance and a capacitor (C) with a corresponding capacitance connected in series and both having the same resistance and capacitance values,
   wherein the positive voltage input (Vin) is connected to the resistor (R) of the resistor-capacitor circuit of the low-pass filter (6), the capacitor (C) of the resistor-capacitor circuit of the low-pass filter (6) is connected to ground and the voltage output (V$_{out}$) is located between the resistor (R) and the capacitor (C) of the resistor-capacitor circuit of the low-pass filter (6), and
   wherein the resistor-capacitor circuit of the high-pass filter (7) is connected between the negative voltage input (-Vin) and the voltage output (V$_{out}$).

2. Passive low-pass filter system (1) according to claims 1, wherein a first digital-to-analog converter (8) is connected to the positive voltage input (V$_{in}$) and a second digital-to-analog converter (9) is connected to the negative voltage input (-V$_{in}$).

3. Passive low-pass filter system (1) according to claim 2, wherein the first digital-to-analog converter (8)

provides a reference voltage (V$_{ref}$) to the positive voltage input (V$_{in}$) in case of a digital one signal and connects the positive voltage input (V$_{in}$) to ground in case of a digital zero signal.

4. Passive low-pass filter system (1) according to claim 2 or claim 3, wherein the second digital-to-analog converter (9) provides a reference voltage (V$_{ref}$) to the negative voltage input (-V$_{in}$) in case of a digital zero signal and connects the negative voltage input (-V$_{in}$) to ground in case of a digital one signal.

5. Passive low-pass filter system (1) according to any of claims 2 to 4, wherein the first digital-to-analog converter (8) and/or the second digital-to-analog converter (9) comprise mechanical or electronic switches, preferably MOS-transistor switches.

6. Passive low-pass filter system (1) according to any of claims 1 to 5, wherein a D-type flip-flop (DFF) is located at the input of the digital signal input (D), wherein the D-type flip-flop (DFF) has an output (Q) and an inverted output ($\bar{Q}$).

7. Passive low-pass filter system (1) according to claim 6, wherein a decoupling circuit (10) is connected to the D-type flip-flop (DFF) to decouple the output (Q) of the D-type flip-flop (DFF) from the inverted output ($\bar{Q}$) of the D-type flip-flop (DFF).

8. Passive low-pass filter system (1) according to claim 7, wherein the decoupling circuit (10) comprises two NOR-gates (11, 12), each NOR-gate (11, 12) having a first input (13), a second input (14) and an output (15), wherein the first input (13) of the first NOR-gate (11) is connected to the output (Q) of the D-type flip-flop (DFF) and the second input (14) of the first NOR-gate (11) is connected to the output (15) of the second NOR-gate (12), and wherein the first input (13) of the second NOR-gate (12) is connected to the inverted output ($\bar{Q}$) of the D-type flip-flop (DFF) and the second input (14) of the second NOR-gate (12) is connected to the output (15) of the first NOR-gate (11).

9. Passive low-pass filter system (1) according to claim 8, wherein the output (15) of the first NOR-gate (11) and/or the output (15) of the second NOR-gate (12) comprises a delay member (16), preferably arranged before a feedback of the output (15) signal to the second input (14) of the other NOR-gate (12, 11).

10. Passive low-pass filter system (1) according to any of claims 7 to 9, wherein the inverted output ($\bar{Q}$) of the D-type flip-flop (DFF) is connected to a first switch (3) between a reference voltage (V$_{ref}$) and the low-pass filter (6) and to a second switch (4) between ground and the high-pass filter (7) and the output (Q) of the D-type flip-flop (DFF) is connected to the second switch (4) between ground and the low-pass filter (6) and to the first switch (3) between the reference voltage ($V_{ref}$) and the high-pass filter (7).

**Patentansprüche**

1.  Passives Tiefpassfiltersystem (1) für Pulsdichte-Digital-Analog-Wandler, umfassend:

    einen positiven Spannungseingang ($V_{in}$) und einen negativen Spannungseingang (-$V_{in}$), die zusammen einen Differenzeingang bilden, einen Spannungsausgang ($V_{out}$), ein Tiefpassfilter (6) und ein Hochpassfilter (7), wobei der positive Spannungseingang ($V_{in}$) mit dem Tiefpassfilter (6) verbunden ist, der Spannungsausgang ($V_{out}$) dem Ausgang des Tiefpassfilters (6) entspricht, der negative Spannungseingang (-$V_{in}$) mit dem Hochpassfilter (7) verbunden ist und der Ausgang des Hochpassfilters (7) mit dem Spannungsausgang ($V_{out}$) verbunden ist, wobei das Tiefpassfilter (6) und das Hochpassfilter (7) jeweils eine Widerstands-Kondensator-Schaltung sind, wobei jede aus einem Widerstand (R) mit einem entsprechenden Widerstandswert und einem Kondensator (C) mit einer entsprechenden Kapazität besteht, in Reihe geschaltet und beide den gleichen Widerstands- und Kapazitätswert aufweisend, wobei der positive Spannungseingang ($V_{in}$) mit dem Widerstand (R) der Widerstands-Kapazitäts-Schaltung des Tiefpassfilters (6) verbunden ist, der Kondensator (C) der Widerstands-Kapazitäts-Schaltung des Tiefpassfilters (6) mit Masse verbunden ist und der Spannungsausgang ($V_{out}$) sich zwischen dem Widerstand (R) und dem Kondensator (C) der Widerstands-Kapazitäts-Schaltung des Tiefpassfilters (6) befindet, und wobei die Widerstands-Kondensator-Schaltung des Hochpassfilters (7) zwischen den negativen Spannungseingang (-$V_{in}$) und den Spannungsausgang ($V_{out}$) geschaltet ist.

2.  Passives Tiefpassfiltersystem (1) nach Anspruch 1, wobei ein erster Digital-Analog-Wandler (8) mit dem positiven Spannungseingang ($V_{in}$) verbunden ist und ein zweiter Digital-Analog-Wandler (9) mit dem negativen Spannungseingang (-$V_{in}$) verbunden ist.

3.  Passives Tiefpassfiltersystem (1) nach Anspruch 2,

    wobei der erste Digital-Analog-Wandler (8) eine Referenzspannung ($V_{ref}$) an den positiven Spannungseingang ($V_{in}$) im Fall eines digitalen Eins-Signals liefert und den positiven Spannungseingang ($V_{in}$) mit Masse im Fall eines digitalen Null-Signals verbindet.

4.  Passives Tiefpassfiltersystem (1) nach Anspruch 2 oder Anspruch 3, wobei der zweite Digital-Analog-Wandler (9) eine Referenzspannung ($V_{ref}$) an den negativen Spannungseingang (-$V_{in}$) im Fall eines digitalen Null-Signals liefert und den negativen Spannungseingang (-$V_{in}$) mit Masse im Fall eines digitalen Eins-Signals verbindet.

5.  Passives Tiefpassfiltersystem (1) nach einem der Ansprüche 2 bis 4, wobei der erste Digital-Analog-Wandler (8) und/oder der zweite Digital-Analog-Wandler (9) mechanische oder elektronische Schalter, bevorzugt MOS-Transistorschalter, umfassen.

6.  Passives Tiefpassfiltersystem (1) nach einem der Ansprüche 1 bis 5, wobei ein D-Typ-Flipflop (DFF) sich an dem Eingang des digitalen Signaleingangs (D) befindet, wobei der D-Typ-Flipflop (DFF) einen Ausgang (Q) und einen invertierten Ausgang **(Q̅)** aufweist.

7.  Passives Tiefpassfiltersystem (1) nach Anspruch 6, wobei eine Entkopplungsschaltung (10) mit dem D-Typ-Flipflop (DFF) verbunden ist, um den Ausgang (Q) des D-Typ-Flipflops (DFF) von dem invertierten Ausgang **(Q̅)** des D-Typ-Flipflops (DFF) zu entkoppeln.

8.  Passives Tiefpassfiltersystem (1) nach Anspruch 7,

    wobei die Entkopplungsschaltung (10) zwei NOR-Gatter (11, 12) umfasst, wobei jedes NOR-Gatter (11, 12) einen ersten Eingang (13), einen zweiten Eingang (14) und einen Ausgang (15) aufweist, wobei der erste Eingang (13) des ersten NOR-Gatters (11) mit dem Ausgang (Q) des D-Typ-Flipflops (DFF) verbunden ist und der zweite Eingang (14) des ersten NOR-Gatters (11) mit dem Ausgang (15) des zweiten NOR-Gatters (12) verbunden ist, und wobei der erste Eingang (13) des zweiten NOR-Gatters (12) mit dem invertierten Ausgang **(Q̅)** des D-Typ-Flipflops (DFF) verbunden ist und der zweite Eingang (14) des zweiten NOR-Gatters (12) mit dem Ausgang (15) des ersten NOR-Gatters (11) verbunden ist.

9.  Passives Tiefpassfiltersystem (1) nach Anspruch 8, wobei der Ausgang (15) des ersten NOR-Gatters (11) und/oder der Ausgang (15) des zweiten NOR-Gatters (12) ein Verzögerungsglied (16) umfasst, bevorzugt angeordnet vor einer Rückkopplung des Signals des Ausgangs (15) zu dem zweiten Eingang (14) des anderen NOR-Gatters (12, 11) .

10. Passives Tiefpassfiltersystem (1) nach einem der Ansprüche 7 bis 9, wobei der invertierte Ausgang (**Q** ) des D-Typ-Flipflops (DFF) mit einem ersten Schalter (3) zwischen einer Referenzspannung ($V_{ref}$) und dem Tiefpassfilter (6) und mit einem zweiten Schalter (4) zwischen Masse und dem Hochpassfilter (7) verbunden ist und der Ausgang (Q) des D-Typ-Flipflops (DFF) mit dem zweiten Schalter (4) zwischen Masse und dem Tiefpassfilter (6) und mit dem ersten Schalter zwischen der Referenzspannung ($V_{ref}$) und dem Hochpassfilter (7) verbunden ist.

**Revendications**

1. Système à filtre passe-bas passif (1) pour des convertisseurs numérique-analogique de densité d'impulsion, comprenant :

   une entrée de tension positive ($V_{in}$) et une entrée de tension négative ($-V_{in}$) formant ensemble une entrée différentielle, une sortie de tension ($V_{out}$), un filtre passe-bas (6) et un filtre passe-haut (7), l'entrée de tension positive ($V_{in}$) étant connectée au filtre passe-bas (6), la sortie de tension ($V_{out}$) correspondant à la sortie du filtre passe-bas (6), l'entrée de tension négative ($-V_{in}$) étant connectée au filtre passe-haut (7) et la sortie du filtre passe-haut (7) étant connectée à la sortie de tension ($V_{out}$),
   le filtre passe-bas (6) et le filtre passe-haut (7) étant chacun un circuit résistance-condensateur, chacun consistant en une résistance (R) avec une résistance correspondante et un condensateur (C) avec une capacité correspondante connectés en série et ayant tous les deux les mêmes valeurs de résistance et de capacité, l'entrée de tension positive ($V_{in}$) étant connectée à la résistance (R) du circuit résistance-condensateur du filtre passe-bas (6), le condensateur (C) du circuit résistance-condensateur du filtre passe-bas (6) étant connecté à la terre et la sortie de tension ($V_{out}$) étant située entre la résistance (R) et le condensateur (C) du circuit résistance-condensateur du filtre passe-bas (6), et
   le circuit résistance-condensateur du filtre passe-haut (7) étant connecté entre l'entrée de tension négative ($-V_{in}$) et la sortie de tension ($V_{out}$).

2. Système à filtre passe-bas passif (1) selon la revendication 1, un premier convertisseur numérique-analogique (8) étant connecté à l'entrée de tension po-

sitive ($V_{in}$) et un deuxième convertisseur numérique-analogique (9) étant connecté à l'entrée de tension négative ($-V_{in}$) .

3. Système à filtre passe-bas passif (1) selon la revendication 2, le premier convertisseur numérique-analogique (8) fournissant une tension de référence ($V_{ref}$) à l'entrée de tension positive ($V_{in}$) en cas de signal à un numérique et connectant l'entrée de tension positive ($V_{in}$) à la terre en cas de signal à zéro numérique.

4. Système à filtre passe-bas passif (1) selon la revendication 2 ou la revendication 3, le deuxième convertisseur numérique-analogique (9) fournissant une tension de référence ($V_{ref}$) à l'entrée de tension négative ($-V_{in}$) en cas de signal à zéro numérique et connectant l'entrée de tension négative ($-V_{in}$) à la terre en cas de signal à un numérique.

5. Système à filtre passe-bas passif (1) selon l'une quelconque des revendications 2 à 4, le premier convertisseur numérique-analogique (8) et/ou le deuxième convertisseur numérique-analogique (9) comprenant des commutateurs mécaniques ou électroniques, de préférence des commutateurs transistors MOS.

6. Système à filtre passe-bas passif (1) selon l'une quelconque des revendications 1 à 5, une bascule de type D (DFF) étant située au niveau de l'entrée de l'entrée de signal numérique (D), la bascule de type D (DFF) ayant une sortie (Q) et une sortie inversée (Q).

7. Système à filtre passe-bas passif (1) selon la revendication 6, un circuit de découplage (10) étant connecté à la bascule de type D (DFF) pour découpler la sortie (Q) de la bascule de type D (DFF) de la sortie inversée (Q) de la bascule de type D (DFF).

8. Système à filtre passe-bas passif (1) selon la revendication 7, le circuit de découplage (10) comprenant deux portes NON-OU (11, 12), chaque porte NON-OU (11, 12) ayant une première entrée (13), une deuxième entrée (14) et une sortie (15), la première entrée (13) de la première porte NON-OU (11) étant connectée à la sortie (Q) de la bascule de type D (DFF) et la deuxième entrée (14) de la première porte NON-OU (11) étant connectée à la sortie (15) de la deuxième porte NON-OU (12), et
   la première entrée (13) de la deuxième porte NON-OU (12) étant connectée à la sortie inversée (Q) de la bascule de type D (DFF) et la deuxième entrée (14) de la deuxième porte NON-OU (12) étant connectée à la sortie (15) de la première porte NON-OU (11).

**9.** Système à filtre passe-bas passif (1) selon la revendication 8, la sortie (15) de la première porte NON-OU (11) et/ou la sortie (15) de la deuxième porte NON-OU (12) comprenant un élément de retard (16), de préférence agencé avant un retour du signal de sortie (15) à la deuxième entrée (14) de l'autre porte NON-OU (12, 11).

**10.** Système à filtre passe-bas passif (1) selon l'une quelconque des revendications 7 à 9, la sortie inversée (Q) de la bascule de type D (DFF) étant connectée à un premier commutateur (3) entre une tension de référence ($V_{ref}$) et le filtre passe-bas (6) et à un deuxième commutateur (4) entre la terre et le filtre passe-haut (7) et la sortie (Q) de la bascule de type D (DFF) étant connectée au deuxième commutateur (4) entre la terre et le filtre passe-bas (6) et au premier commutateur (3) entre la tension de référence ($V_{ref}$) et le filtre passe-haut (7).

Fig. 1
(Prior art)

Fig. 2

Fig. 3

Fig. 4a

Fig. 4b

Fig. 5

Fig. 6

EP 3 648 354 B1

**REFERENCES CITED IN THE DESCRIPTION**

**Patent documents cited in the description**

- US 5815051 A
- US 20160373101 A1
- US 20120007215 A1